(19) Europäisches Patentamt
European Patent Office
Office européen des brevets

(11) **EP 4 063 798 B1**

(12) **EUROPÄISCHE PATENTSCHRIFT**

(45) Veröffentlichungstag und Bekanntmachung des Hinweises auf die Patenterteilung:
**06.11.2024 Patentblatt 2024/45**

(21) Anmeldenummer: **22000050.9**

(22) Anmeldetag: **07.03.2022**

(51) Internationale Patentklassifikation (IPC):
**G01D 4/00** (2006.01) **G01R 21/133** (2006.01)

(52) Gemeinsame Patentklassifikation (CPC):
**G01R 21/133; G01R 19/2513**

(54) **ANORDNUNG UND VERFAHREN ZUR ERMITTLUNG ELEKTRISCHER KENNGRÖSSEN EINES VERBRAUCHERS IN EINEM VERZWEIGTEN STROMNETZ**

ASSEMBLY AND METHOD FOR DETERMINING ELECTRICAL CHARACTERISTICS OF A CONSUMER IN A BRANCHED POWER NETWORK

DISPOSITIF ET PROCÉDÉ DE DÉTERMINATION DES GRANDEURS CARACTÉRISTIQUES ÉLECTRIQUES D'UN CONSOMMATEUR DANS UN RÉSEAU ÉLECTRIQUE RAMIFIÉ

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **22.03.2021 DE 102021001470**

(43) Veröffentlichungstag der Anmeldung:
**28.09.2022 Patentblatt 2022/39**

(73) Patentinhaber: **Ampect GmbH**
**73479 Ellwangen (DE)**

(72) Erfinder:
• **Schmidt, Dirk**
**73479 Ellwangen (DE)**

• **Puntigam, Fabian**
**70193 Stuttgart (DE)**

(74) Vertreter: **Weihrauch, Frank et al**
**Dr. Weihrauch & Haussingen**
**Patent- und Rechtsanwälte**
**W.-Seelenbinder-Straße 17**
**98529 Suhl (DE)**

(56) Entgegenhaltungen:
**EP-A1- 2 549 280 EP-A1- 2 960 664**
**GB-A- 2 452 989**

**Beschreibung**

Die Erfindung betrifft eine Anordnung und ein Verfahren zur Ermittlung elektrischer Kenngrößen von Verbrauchern in einem verzweigten Stromnetz.

Aus dem Stand der Technik sind Systeme zur Ermittlung elektrischer Kenngrößen von Verbrauchern in einem verzweigten Stromnetz, welche den Stromverbrauch direkt beim Verbraucher messen, dem Grunde nach bekannt.

So beschreibt beispielsweise DE 10 2011 107 932 B3 ein System, welches elektrische Kenngrößen wie Wirkleistungswerte aus dezentral gemessenen Momentanwerten des Stroms und einer zentral ermittelten Spannung in einer zentralen Recheneinheit errechnet. Die zeitliche Synchronisation der Messdaten erfolgt anhand von digitalen Zeitstempeln. Die Lösung stellt sehr exakte Ergebnisse bereit und erfordert zugleich eine hohe Datenübertragungsrate.

Ferner ist aus EP 2 960 664 A1 ein System zur Erfassung von Leistungen und Energiemengen für eine Mehrzahl von dezentralen Verbrauchern bekannt, bei dem eine Messspannung als Schutzkleinspannung zentral aus der anliegenden Niederspannung erzeugt wird. Im Falle einer analogen Übertragung wird die Messspannung durch ein dezentrales Modul mit analogem Eingang und im Falle einer digitalen Übertragung durch ein dezentrales Modul mit digitalem Eingang ausgewertet.

Weiterhin beschreibt GB 2 452 989 A eine Anordnung zum Erfassen der Leistung und des Energieverbrauchs in einem verzweigten Stromkreis, wobei hier eine zentrale Spannungserfassungsvorrichtung vorgesehen ist, die über eine mehradrige Leitung die dezentralen Stomerfassungseinrichtungen sowohl mit einem Spannungssignal als auch mit einer Betriebsspannung versorgt.

Aufgabe der Erfindung ist es, ein System für eine einfache und präzise Berechnung elektrischer Kenngrößen von dezentralen Verbrauchern in einem verzweigten Stromnetz bereitzustellen, das störunanfällig arbeitet und kostengünstig bereitstellbar ist.

Die Aufgabe wird in Bezug auf die Anordnung durch die im Patentanspruch 1 aufgeführten Merkmale gelöst. Bevorzugte Weiterbildungen ergeben sich aus den Unteransprüchen. In Bezug auf das Verfahren wird die Aufgabe durch die im Patentanspruch 6 aufgeführten Merkmale gelöst.

Die Anordnung zur Ermittlung elektrischer Kenngrößen von Verbrauchern in einem verzweigten Stromnetz weist erfindungsgemäß eine zentrale Spannungswandlereinheit und eine Mehrzahl dezentraler Einheiten auf.

Die zentrale Spannungswandlereinheit ist erfindungsgemäß ausgebildet, einen Spannungsverlauf an einer Stelle des verzweigten Stromnetzes zu erfassen. Dies wird als zentrale Spannungserfassung im Sinne der vorliegenden Anmeldung verstanden. Die zentrale Spannungswandlereinheit ist ferner ausgebildet, aus der zentral erfassten Spannung ein Spannungsreferenzsignal zu erzeugen. Das Spannungsreferenzsignal wird in einer Sicherheitskleinspannung beispielsweise von 5 Volt, 12 Volt oder 24 Volt bereitgestellt. Bei dem Spannungsreferenzsignal handelt es sich um einen proportional zu dem erfassten Spannungsverlauf reduzierten Spannungsverlauf. Dabei besteht ein Wandlungsfaktor, der das Größenverhältnis zwischen dem erfassten Spannungsverlauf und dem Spannungsreferenzsignal definiert. Das Spannungsreferenzsignal liegt als analoges Signal vor. Es stellt ein in Echtzeit erzeugtes, reduziertes Abbild des erfassten Spannungsverlaufs dar.

Die Spannungswandlereinheit erfasst bevorzugt die an einem dreiphasigen Stromnetz anliegende Spannung von 230 V jeweils zwischen einer Phase und dem Nullleiter und erzeugt ein analoges dreiphasiges Spannungsreferenzsignal, reduziert auf den Wert einer Sicherheitskleinspannung. Typischerweise werden immer alle drei Phasen zu einem dann dreiphasigen Spannungsreferenzsignal gewandelt. Soweit ein Verbraucher lediglich einer Phase zugeordnet ist, muss ein lediglich einphasiges Spannungsreferenzsignal erzeugt werden.

Der genaue Verlauf des einzelnen sinusförmigen Spannungsverlaufs einschließlich Lage der Maxima (Amplituden) und der Nulldurchgänge sowie die Lage der Spannungsverläufe der Phasen zueinander wird dabei nicht verändert. Das auf Sicherheitskleinspannung reduzierte Spannungsreferenzsignal der benötigten Phasen steht nun übertragbar bereit und kann als analoges Signal an andere Komponenten übertragen werden.

Die Übertragung des Spannungsreferenzsignal erfolgt über die Spannungssignalverbindung vorzugsweise kabelgebunden. Optional kann das Spannungsreferenzsignal bei kleiner Spannung und bei einer großen Übertragungsentfernung verstärkt werden.

Die Spannungssignalverbindung weist einen digitalen Spannungssignalverbindungsabschnitt auf. Mit dem Analog-Digital-Wandler, nachfolgenden auch A/D-Wandler genannt, wird das zunächst als analoges Spannungsreferenzsignal in einer Sicherheitskleinspannung vorliegende Spannungsreferenzsignal in ein digitales Format, nachfolgend digitales Spannungsreferenzsignal genannt, umgewandelt und ab dann über den digitalen Spannungssignalverbindungsabschnitt übertragen. Am Ende des digitalen Spannungssignalverbindungsabschnitts ist der Digital-Analog-Wandler, nachfolgend auch D/A-Wandler genannt, angeordnet, der das digitale Spannungsreferenzsignal wieder in ein analoges Spannungsreferenzsignal rückumwandelt. Das Spannungsreferenzsignal liegt wieder als analoges Spannungsreferenzsignal in Sicherheitskleinspannung vor und wird weiter übertragen. Der digitale Spannungssignalverbindungsabschnitt ist vorzugsweise drahtgebunden ausgebildet; er kann jedoch auch drahtlos als Funkverbindung ausgebildet sein. Ferner können optional über den digitalen Spannungssignalverbindungsabschnitt auch über das digitale Spannungsreferenzsignal hinaus Daten übertragen werden, wobei es sich sowohl um ergänzende Daten zum Spannungsreferenzsignal als auch um sonstige Daten handeln kann. Zudem kann die Übertragung dieser Daten sowohl unidirektional als auch bidirektional erfolgen.

Es ist zudem möglich, bei den mehreren dezentralen Einheiten die Spannungssignalverbindung unterschiedlich auszubilden. So ist es von der Erfindung ebenfalls umfasst, wenn nicht alle Spannungssignalverbindungen einen digitalen Spannungssignalverbindungsabschnitt mit A/D- und D/A-Wandler aufweisen. So kann die Spannungssignalverbindung zu einer oder zu mehreren dezentralen Einheiten auch als analoge Spannungssignalverbindung ausgebildet sein. Weiter ist es möglich, dass die Spannungssignalverbindung zu einer oder zu mehreren dezentralen Einheiten einen A/D-Wandler und einen digitalen Spannungssignalverbindungsabschnitt aufweist und hierbei das Spannungsreferenzsignal direkt als digitales Spannungsreferenzsignal an die jeweilige dezentrale Einheit übergibt. Dies wird jedoch nicht beansprucht.

Ferner kann der A/D-Wandler baulich in die zentrale Spannungswandlereinheit integriert sein. Der D/A-Wandler kann baulich in die jeweilige dezentrale Auswertungseinheit integriert sein.

Erfindungsgemäß liegt neben der zentralen Spannungswandlereinheit eine Mehrzahl dezentraler Einheiten vor.

Die dezentralen Einheiten sind jeweils den Verbrauchern zugeordnet. Jede dezentrale Einheit weist eine dezentrale Strommessanordnung sowie eine dezentrale Auswertungseinheit auf. Eine solche dezentrale Einheit ist baulich typischerweise als ein Gerät ausgebildet, in dem eine dezentrale Strommesseinheit und die dezentrale Auswertungseinheit integriert sind. Um die tatsächliche Leistungsabnahme eines Verbrauchers in einem verzweigten Stromnetz zu ermitteln, werden die dezentralen Einheiten den einzelnen Verbrauchern oder auch Gruppen von Verbrauchern zugeordnet. Nachfolgend werden einzelne Verbraucher und Gruppen von Verbrauchern auch zusammengefasst als Verbraucher bezeichnet.

Die jeweilige dezentrale Einheit weist eine Strommessanordnung auf, welche mittels mindestens eines Stromsensors die fließenden Ströme lokal bei dem betreffenden Verbraucher erfasst. Es wird jeweils ein Stromsensor für jeden zu messenden Leiter eingesetzt. Einem dreiphasigen Verbraucher sind somit regelmäßig drei Stromsensoren zugeordnet. Die Strommessanordnung kann optional auch eine größere Anzahl von Stromsensoren, beispielsweise neun Stromsensoren aufweisen. In einer solchen Variante kann eine Strommessanordnung die Ströme mehrerer Verbraucher erfassen. Die Stromsensoren sind vorzugsweise Klappstromwandler oder Rogowskispulen, die die Stromstärke berührungslos messen und die um die installierten Leiter gelegt werden, ohne diese Leiter von der Installation zu trennen.

Die Strommessanordnung ist erfindungsgemäß ausgebildet, Augenblickswerte eines Stroms kontinuierlich zu messen und übertragbar bereitzustellen. Die Strommessanordnung ermittelt in Echtzeit die Augenblickswerte des Stromes und stellt diese in einer übertragbaren Form zur Übertragung über die Stromsignalverbindung bereit.

Hierbei kann die Strommessanordnung vorzugsweise ferner mindestens eine Strommesseinheit aufweisen, mit der die Strommesssensoren verbunden sind und welche das von den Stromsensoren erhaltene Messsignal in ein Signalformat umwandelt, welches von der dezentralen Auswertungseinheit verarbeitbar ist. Die konkrete Ausbildung der Strommesseinheit bestimmt sich nach der Bauart und der Anzahl der Stromsensoren. Die Stromsensoren und die Strommesseinheit können baulich integriert, aber auch baulich getrennt angeordnet sein. Soweit die dezentrale Auswertungseinheit das von den Stromsensoren ausgehende Signal ohne Konvertierung verarbeiten kann, kann die Strommessanordnung auch ohne Strommesseinheit ausgebildet sein. Von der Strommessanordnung wird somit in jedem Fall der dezentralen Auswertungseinheit ein von ihr verarbeitbares Signal zur Verfügung gestellt.

Erfindungsgemäß weist die dezentrale Einheit ferner eine dezentrale Auswertungseinheit auf.

Die jeweilige dezentrale Auswertungseinheit ist mittels einer Spannungssignalverbindung mit der zentralen Spannungswandlereinheit und mittels einer Stromsignalverbindung mit der jeweiligen dezentralen Strommessanordnung verbunden. Die dezentrale Auswertungseinheit der dezentralen Einheit erhält über die Spannungssignalverbindung das Spannungsreferenzsignal mit den Augenblickswerten der Spannung und über die Stromsignalverbindung die Augenblickswerte des Stroms.

Die dezentrale Auswertungseinheit ist erfindungsgemäß ausgebildet, aus dem Spannungsreferenzsignal die Augenblickswerte der Spannung zu detektieren und die Augenblickswerte der Spannung den Augenblickswerten des Stroms zuzuordnen. Die dezentrale Auswertungseinheit detektiert aus dem Spannungsreferenzsignal die Augenblickswerte der Spannung und ordnet diese dann den von der dezentralen Strommessanordnung erhaltenen Augenblickswerten des Stroms zu.

Die dezentrale Auswertungseinheit ist ferner ausgebildet, aus den zugeordneten Augenblickswerten der Spannung und des Stroms sowie aus dem Wandlungsfaktor die elektrische Wirkleistung des jeweiligen Verbrauchers als eine elektrische Kenngröße zu berechnen.

Aus den zugeordneten Augenblickswerten für Spannung und Strom sind durch die dezentrale Auswertungseinheit ferner bevorzugt weitere elektrische Kenngrößen wie Scheinleistung, Blindleistung und die Phasenverschiebung Phi bestimmbar. Die weiteren elektrischen Kenngrößen können zur besseren Charakterisierung des Stromnetzes und der Verbraucher genutzt werden.

Die nun ermittelten elektrischen Kenngrößen können direkt über die zentrale Datenverbindung, vorzugsweise über einen digitalen Bus, ausgelesen werden.

Die Lösung weist insbesondere nachfolgende Vorteile auf.

Durch die Trennung der Spannungsmessung von der Strommessung ergibt sich der Vorteil, dass die dezentralen Einheiten bei dem Verbraucher weniger komplex und damit kostengünstiger ausgebildet werden können. Baueinheiten mit einer zur Messung von Augenblickswerten des Stroms sowie Auswertungseinheiten, welche aus analogen Signalen Augenblickswerte des Stroms und Augenblickswerte der Spannung sowie hierauf aufbauend eine Wirkleistung ermitteln können, sind als solche aus dem Stand der Technik bekannt und vergleichsweise kostengünstig auf dem Markt verfügbar. Diese können als dezentrale Einheiten im Sinne der vorliegenden Erfindung eingesetzt werden.

Durch die Verwendung eines reduzierten Spannungssignals können die Module der dezentralen Einheiten kleiner, einfacher und kostengünstiger ausgelegt werden, da eine sonst erforderliche Messtechnik für 230 V Wechselspannung größer ausgelegt ist und somit mehr Bauraum einnehmen würde.

Ein weiterer Vorteil ist es, dass das reduzierte Spannungssignal über eine Verbindungsleitung mit einem geringeren Leiterquerschnitt übertragen und somit sehr einfach in eine vorhandene Infrastruktur integriert werden kann. Zudem bestehen aufgrund der Ausbildung des reduzierten Spannungsreferenzsignals als Sicherheitskleinspannung keine zusätzlichen Sicherheitsanforderungen an die Installation und an den Betrieb. Auch somit wird der Aufwand für die Verdrahtung reduziert. Die Verbindung der zentralen Spannungswandlereinheit, der dezentralen Einheiten und optional der zentralen Ausgabe- und Serviceeinheit wird vorzugsweise physisch als CAT 5 LAN Signalleitungen ausgebildet, so dass die zentrale Datenverbindung und die Spannungssignalverbindung physisch in einer Leitung integriert sind. Vorteilhaft ist hierbei ferner die Signalwandlung über einen A/D-Wandler und umgekehrt über einen D/A-Wandler, so dass die Übertragung im digitalen Format und somit auch bei einer drahtlosen Übertragung besonders stabil ist.

Zu dem drastisch verringerten Aufwand für die Hardware kommt der deutlich verringerte Aufwand beim Anschluss der dezentralen Einheiten an die Verbraucher hinzu. Der Anschluss der Stromsensoren erfolgt ohne Eingriff in das Stromnetz. Es müssen ausschließlich einmal bei dem Anschluss der zentralen Spannungswandlereinheit die stromführenden Leitungen angeschlossen werden. Damit wird erreicht, dass kein für das jeweilige verzweigte Stromnetz, in der Regel also für die betriebliche Elektroanlage, zugelassener Elektriker erforderlich ist, um die teilweise sehr vielen dezentralen Einheiten anzuschließen.

Nach einem weiteren Aspekt der Erfindung gemäß dem Patentanspruch 2 weist die erfindungsgemäße Anordnung den gleichen Aufbau wie vorstehend zu Patentanspruch 1 beschrieben mit der Maßgabe auf, dass die Anordnung so ausgebildet ist, dass das digitale Spannungsreferenzsignal direkt an die dezentrale Einheit übertragen wird, so dass dort kein D/A-Wandler vorgeschaltet ist. Vielmehr ist nach diesem Aspekt der Erfindung die dezentrale Auswertungseinheit so ausgebildet, dass diese unmittelbar ein digitales Spannungsreferenzsignal verarbeiten und hieraus die Augenblickswerte der Spannung detektieren kann. Im Übrigen stimmt die Anordnung gemäß Patentanspruch 2 mit der Anordnung gemäß Patentanspruch 1 überein, so dass die dortigen Beschreibungsinhalte auch hier gelten.

Gemäß einer vorteilhaften Weiterbildung ist die dezentrale Strommessanordnung in die dezentrale Auswertungseinheit integriert. Durch eine bauliche Verbindung von dezentraler Strommessanordnung und dezentraler Auswertungseinheit ergeben sich Vorteile bei der Herstellung, welche einen höheren Grad der Miniaturisierung und geringere Herstellungskosten ermöglichen. Ferner ist es möglich, dass nur Teile der dezentralen Strommessanordnung in die dezentrale Auswertungseinheit integriert sind.

Die dezentrale Auswertungseinheit ist gemäß einer vorteilhaften Weiterbildung ausgebildet, aus den Augenblickswerten der Spannung und des Stroms einen Phasenwinkel φ (Phi) als eine elektrische Kenngröße zu berechnen.

Der Phasenwinkel φ (Phi) oder auch als Phasenverschiebungswinkel bezeichnet, ist ein Maß für die Phasenverschiebung zwischen Strom und Spannung. Vorzugsweise kann auch der Wirkfaktor cos φ errechnet werden. Der Wirkfaktor kann auch als Quotient von Wirkleistung P und Scheinleistung S angegeben werden.

Gemäß einer vorteilhaften Weiterbildung weist mindestens eine dezentrale Einheit eine dezentrale Ausgabe- und Serviceeinheit auf.

Die dezentrale Auswertungseinheit der mindestens einen dezentralen Einheit weist gemäß einer vorteilhaften Weiterbildung eine dezentrale Datenverbindung zu der dezentralen Ausgabe- und Serviceeinheit auf. Die dezentrale Ausgabe- und Serviceeinheit ist ausgebildet, die über die dezentrale Datenverbindung erhaltenen elektrischen Kenngrößen der dezentralen Einheiten dezentral auszugeben.

Eine dezentrale Ausgabe- und Serviceeinheit erlaubt vorteilhaft ein direktes Auslesen und Auswerten der Daten der dezentralen Auswertungseinheit in räumlicher Nähe zu dem jeweiligen Verbraucher. Dies kann insbesondere dann vorteilhaft sein, wenn das elektrische Verhalten spezieller Verbraucher von besonderem Interesse ist und zusammen mit deren Betriebszuständen beobachtet werden soll.

Die dezentrale Ausgabe- und Serviceeinheit ist vorzugsweise als ein Computer, ein Tablett oder ein Smartphone ausgebildet und kann die Daten optisch vorzugsweise durch ein Display ausgeben.

Der Vorteil liegt hier je nach Ausbildung entweder in der Möglichkeit der direkten Überwachung der Kenngrößen oder in der Möglichkeit, die Kenngrößen auf andere Geräte zu übertragen und optional anderweitig auszuwerten oder die dezentrale Einheit ohne eine zentrale Datenverbindung in Betrieb zu nehmen, Parameter der zentralen Einheit zu verändern oder Zuordnungen der zu messenden Leiter zu den Verbrauchern zu treffen.

Gemäß einer vorteilhaften Weiterbildung weist das System zur Ermittlung elektrischer Kenngrößen von Verbrauchern in einem verzweigten Stromnetz eine zentrale Ausgabe- und Serviceeinheit auf.

Die zentrale Ausgabe- und Serviceeinheit ist gemäß dieser vorteilhaften Weiterbildung über eine zentrale Datenverbindung mit den dezentralen Auswertungseinheiten verbunden und ausgebildet, die über die zentrale Datenverbindung erhaltenen elektrischen Kenngrößen der dezentralen Einheiten zentral auszugeben. Vorzugsweise ist die zentrale Ausgabe- und Serviceeinheit ferner ausgebildet, die elektrischen Kenngrößen zu aggregieren, in bestimmte Datenformate zu wandeln und sie in einer Datenbank zu speichern. Weiterhin ist die zentrale Ausgabe- und Serviceeinheit vorzugsweise als Bus Master für die dezentralen Auswertungseinheiten ausgebildet.

Die zentrale Ausgabe- und Serviceeinheit kann die elektrischen Kenngrößen aller dezentralen Einheiten, welche mit einer zentralen Datenverbindung verbunden sind, abrufen und ausgeben sowie vorzugsweise weitere Berechnungen auf der Grundlage der elektrischen Kenngrößen ausführen. Die Ausgabe kann optisch, beispielsweise durch ein Display, oder digital über ein Dateninterface wie beispielsweise Ethernet oder USB erfolgen. Die Ausgabe der Daten kann in unterschiedlichen Datenformaten erfolgen. Vorzugsweise werden die ermittelten elektrischen Kenngrößen aller Verbraucher in einer Datenbank abgelegt, strukturiert und verarbeitet. Dabei ist es möglich, dass die Datenbank in der zentralen Ausgabe- und Serviceeinheit oder in einer anderen angeschlossenen Datenverarbeitungsanlage angeordnet ist. Ferner kann die zentrale Ausgabe- und Serviceeinheit als eine Datenverarbeitungsanlage mit einem Datenspeicher in der Cloud ausgebildet sein. Die zentrale Datenverbindung ist über aus dem Stand der Technik bekannte Standards zur Datenfernübertragung wie beispielsweise WAN, LAN, W-LAN, Ethernet, Funk, Internet und so weiter realisierbar.

Vorzugsweise handelt es sich bei der zentralen Datenverbindung um einen digitalen Bus. Somit kann die zentrale Ausgabeeinheit im Sinne dieser Weiterbildung auch durch ein externes System bereitgestellt werden. Bei einem solchen externen System kann es sich beispielsweise um eine betriebliche elektronische Datenverarbeitungsanlage, also um ein Computersystem oder um ein Automatisierungssystem, handeln. Ferner kann die zentrale Ausgabe- und Serviceeinheit auch ortsfremd, insbesondere als Cloudsystem, angeordnet sein und eine Fernüberwachung und Fernauswertung ermöglichen. Weiterhin ist es möglich, dass die zentrale Datenverbindung physisch zumindest abschnittsweise den digitalen Spannungssignalverbindungsabschnitt nutzt.

Das Verfahren zur Ermittlung elektrischer Kenngrößen von Verbrauchern in einem verzweigten Stromnetz ist erfindungsgemäß dadurch gekennzeichnet, dass es mittels einer zentralen Spannungswandlereinheit und einer Mehrzahl von dezentralen Einheiten, welche den Verbrauchern zugeordnet sind und jeweils eine dezentrale Strommessanordnung mit mindestens einem Stromsensor sowie jeweils eine dezentrale Auswertungseinheit aufweisen, durchgeführt wird.

Dabei ist erfindungsgemäß die Spannungswandlereinheit mittels einer Spannungssignalverbindung mit der dezentralen Auswertungseinheit und die dezentrale Strommessanordnung mittels einer Stromsignalverbindung mit der dezentralen Auswertungseinheit verbunden. Das Verfahren wird somit mittels einer Anordnung zur Ermittlung elektrischer Kenngrößen von Verbrauchern in einem verzweigten Stromnetz durchgeführt, wie sie vorstehend beschrieben wurde, so dass die Beschreibungsinhalte zu der Anordnung auch in Bezug auf das Verfahren gelten.

Das Verfahren zur Ermittlung elektrischer Kenngrößen von Verbrauchern in einem verzweigten Stromnetz weist erfindungsgemäß folgende Verfahrensschritte auf.

a) Zentrales Erfassen einer Spannung durch den zentralen Spannungswandler

b) Wandeln der Spannung in ein Spannungsreferenzsignal, indem der Spannungsverlauf um einen Wandlungsfaktor proportional auf eine Sicherheitskleinspannung reduziert wird

c) Übertragen des Spannungsreferenzsignals über die Spannungssignalverbindung an die dezentrale Auswertungseinheit, hierbei Wandeln des analogen Spannungsreferenzsignals mittels des Analog-Digital-Wandlers in ein digitales Spannungsreferenzsignal, Übertragen des digitalen Spannungsreferenzsignals über den digitalen Spannungssignalverbindungsabschnitt und Wandeln des digitalen Spannungsreferenzsignals mittels des Digital-Analog-Wandlers

d) dezentrales Erfassen von Augenblickswerten eines Stroms durch die dezentralen Strommessanordnungen

e) Übertragen der Augenblickswerte des Stroms mittels der Stromsignalverbindung an die dezentrale Auswertungseinheit

f) Ermitteln von Augenblickswerten der Spannung anhand des Spannungsreferenzsignals durch die dezentrale Auswertungseinheit

g) Zuordnung der Augenblickswerte der Spannung und des Stroms

h) Berechnen der Wirkleistung aus den zugeordneten Augenblickswerten der Spannung und des Strom und des Wandlungsfaktors

Die Verfahrensschritte werden nachfolgend näher beschrieben:

a) Zentrales Erfassen einer Spannung durch den zentralen Spannungswandler Der Spannungswandler erfasst den Verlauf der Spannung in dem Stromnetz an einer zentralen Stelle. Hierbei ist die zentrale Stelle möglichst nahe an dem Einspeisepunkt und vor der Verzweigung des Stromnetzes angeordnet.

b) Wandlung der Spannung in ein Spannungsreferenzsignal, indem der Spannungsverlauf um einen Wandlungsfaktor proportional auf eine Sicherheitskleinspannung reduziert wird.

Die Netzspannung wird dabei bevorzugt galvanisch sicher von der Sicherheitskleinspannung getrennt, so dass in allen anderen Komponenten, insbesondere in den dezentralen Einheiten sowie in allen Verbindungen lediglich die Regeln für Sicherheitskleinspannungen beachtet werden müssen.

Der erfasste Spannungsverlauf, beispielsweise bei 230 Volt, wird in ein Spannungsreferenzsignal mit einer geringeren Spannung, beispielsweise mit 12 Volt, umgewandelt. Hierbei werden die Signalformen der einzelnen Spannungen sowie die Phasenlagen der Spannungen relativ zu dem Stromverlauf beibehalten und um einen Wandlungsfaktor auf eine Sicherheitskleinspannung proportional reduziert. Insbesondere bleiben hierbei die Periodenlängen des sinusförmigen Signals erhalten. Der gemessene analoge Spannungsverlauf wird in ein analoges Spannungsreferenzsignal umgewandelt.

c) Übertragung des Spannungsreferenzsignals über die Spannungssignalverbindung an die dezentrale Auswertungseinheit, hierbei Wandeln des analogen Spannungsreferenzsignals mittels des Analog-Digital-Wandlers in ein digitales Spannungsreferenzsignal, Übertragen des digitalen Spannungsreferenzsignals über den digitalen Spannungssignalverbindungsabschnitt und Wandeln des digitalen Spannungsreferenzsignals mittels des Digital-Analog-Wandlers

Das erzeugte Spannungsreferenzsignal wird über die Spannungssignalverbindung an die dezentrale Auswertungseinheit übertragen. Die Übertragung erfolgt in dem digitalen Spannungssignalverbindungsabschnitt digital sowie im Übrigen analog und vorzugsweise kabelgebunden. Die Wandung des analogen Spannungsreferenzsignals in ein digitales Spannungsreferenzsignal wird mittels des Analog-Digital-Wandlers durchgeführt. Umgekehrt wird die Wandlung des digitalen Spannungsreferenzsignals in ein analoges Spannungsreferenzsignal mittels des Digital-Analog-Wandlers durchgeführt. Somit steht allen dezentralen Auswertungseinheiten das Spannungsreferenzsignal in Echtzeit zur Verfügung.

d) dezentrales Erfassen von Augenblickswerten eines Stroms durch die dezentralen Strommessanordnungen

Die Augenblickswerte des Stroms am Verbraucher werden von der jeweiligen zugeordneten dezentralen Strommessanordnung mittels Stromsensoren, vorzugsweise mittels drei Stromsensoren aus den Stromverläufen der drei stromführenden Phasen (L1 bis L3) ermittelt. Die dezentrale Strommessanordnung weist zudem bevorzugt eine Strommesseinheit auf und stellt die Augenblickswerte des Stroms in einem geeigneten Signaltyp für eine Übertragung an die jeweilige dezentrale Auswertungseinheit bereit.

e) Übertragen der Augenblickswerte des Stroms mittels der Stromsignalverbindung an die dezentrale Auswertungseinheit

Die von den Stromsensoren der Strommessanordnung abgenommenen und vorzugsweise von der Strommesseinheit aufbereiteten Augenblickswerte des Stroms werden über die Stromsignalverbindung an die dezentrale Auswertungseinheit übertragen. Diese Stromsignalverbindung kann drahtgebunden oder über Funk ausgebildet sein. Die Strommesseinheit kann dabei verschiedene, sich aus dem Stand der Technik ergebende Signalformen ausgeben. Optional kann die Strommessanordnung bei der Umwandlung zusätzlich Metadaten wie Identifikationsdaten oder Standortdaten der Strommessanordnung hinzufügen.

f) Ermitteln von Augenblickswerten der Spannung anhand des Spannungsreferenzsignals durch die dezentrale Auswertungseinheit

Die dezentrale Auswertungseinheit ermittelt aus dem Spannungsreferenzsignal die Augenblickswerte der Spannung. Durch die beibehaltene Signalform, die beibehaltene Phasenverschiebung der Spannung zum Strom und die Zuordnung der Phasenlage der Spannungen können nachfolgend alle relevanten elektrischen Kenngrößen berechnet werden. Zudem kann optional ein Auslesen der charakteristischen Punkte im Spannungsreferenzsignal, wie beispielsweise der Nulldurchgänge und Amplituden erfolgen, um so beispielsweise eine Grundlage für eine Ermittlung einer Phasenverschiebung zu erhalten.

g) Zuordnung der Augenblickswerte der Spannung und des Stroms in Echtzeit

Die Auswertungseinheit ordnet die Augenblickswerte der Spannung und die Augenblickswerte des Stroms einander zu. Die Zuordnung der Augenblickswerte der Spannung und der Augenblickswerte des Stroms erfolgt in Echtzeit (zeitsynchron). Durch das Prinzip der Zuordnung in Echtzeit entfällt als besonderer Vorteil das Erfordernis, die Augenblickswerte der Spannung und des Stroms beispielsweise durch Zeitstempel zeitlich identifizierbar zu machen.

h) Berechnen der Wirkleistung aus den zugeordneten Augenblickswerten der Spannung und des Strom sowie aus dem Wandlungsfaktor

In diesem Verfahrensschritt erfolgt die Berechnung der Wirkleistung und optional weiterer elektrischer Kenngrößen aus den Momentanwerten der Spannung u(t) und des Stromes i(t), genauer, aus ihrem individuellen zeitlichen Verlauf und dem gegenseitigen zeitlichen Bezug. Die Berechnung der Kenngrößen erfolgt hier unter Beachtung des Wandlungsfaktors.

Durch den periodisch widerkehrenden Verlauf der Signale mit der Periodendauer T lassen sich bevorzugt Vereinfachungen treffen, indem die Verläufe von Strom, Spannung und Leistung einer Periode in einer spezifischen Kenngröße zusammengefasst werden, die dann für Berechnungen vergleichbar mit der Gleichstromrechnung ohne spezielle Integralrechnung herangezogen werden können. Diese Kenngrößen sind allgemein bekannt und werden bei der Beschreibung der Zustände im Versorgungsnetz verwendet und können durch entsprechende Messtechnik erfasst werden. Die bekanntesten davon sind die Effektivgrößen, bei denen es sich um den quadratischen Mittelwert der betrachteten Ausgangsgröße handelt.

$$P = \bar{p} = \frac{1}{T} \int_{t_0}^{t_0+T} u(t) * i(t)\,dt$$

$$U_{eff} = \sqrt{\frac{1}{T} \int_{t_1}^{t_1+T} u(t)^2\,dt}$$

$$I_{eff} = \sqrt{\frac{1}{T} \int_{t_1}^{t_1+T} i(t)^2\,dt}$$

$$S = U_{eff} * I_{eff} = \sqrt{P^2 + Q^2}$$

$$Q = \sqrt{S^2 - P^2}$$

$$PF = \frac{|P|}{S} = \cos(\varphi)\ (im\ Falle\ eines\ linearen\ verbrauchers)$$

$$E = W = \int_{t_0}^{t_1} P(t)\,dt,\ falls\ P\ nicht\ zeitlich\ konstant$$

$$E_q = W_q = \int_{t_0}^{t_1} Q(t)\,dt,\ falls\ Q\ nicht\ zeitlich\ konstant$$

$P$: Wirkleistung innerhalb einer Netzwperiode [$W$]
$U_{eff}$: Effektivwert der Spannung [$V$]
$I_{eff}$: Effektivwert des Stromes [$A$]
$S$: Scheinleistung [$VA$]
$Q$: Blindleistung [$Var$]
$PF$: Power Factor
$E$: Wirkenergie [$Ws$]
$E_q$: Blindenergie [$Vars$]

Die vom Verbraucher dem Stromnetz entnommene Wirkleistung steht ausgebbar zur Verfügung. Optional kann die Wirkleistung auch zwischengespeichert werden. Die Ausgabe erfolgt durch entsprechende Ausgabeeinheiten, durch Anzeige oder anderweitige Ausgabe. Die Ausgabeeinheiten können auch in die dezentralen Auswertungseinheiten integriert sein.

Die Erfindung wird an einem Ausführungsbeispiel der Anordnung anhand von

Fig. 1    Blockschaltbild mit detaillierter Darstellung einer dezentralen Einheit

Fig. 2    Blockschaltbild mit Darstellung mehrerer Verbraucher

näher erläutert. Hierbei wird zugleich ein Ausführungsbeispiel des Verfahrens erläutert.

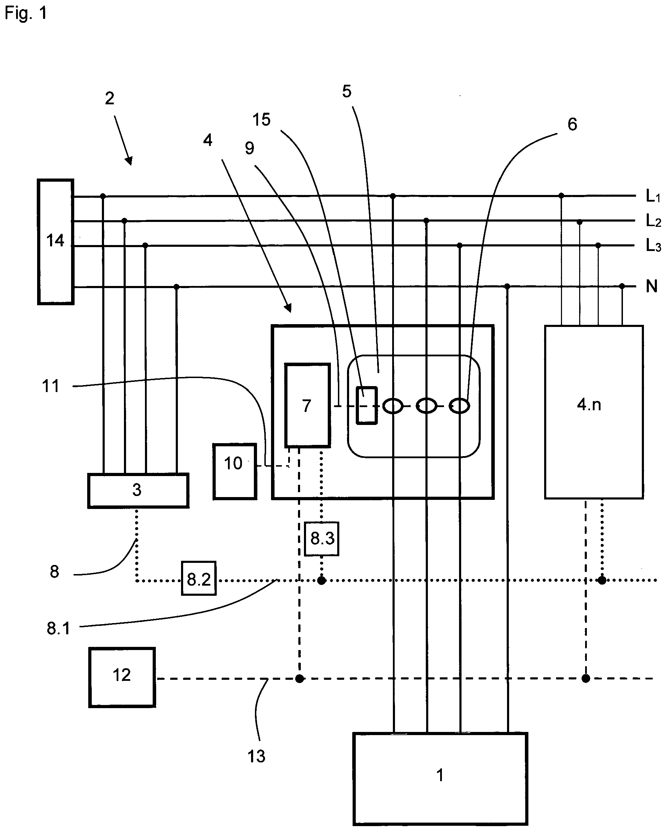

Figur 1 zeigt eine Darstellung eines Ausführungsbeispiels der Anordnung zur Ermittlung elektrischer Kenngrößen von Verbrauchern in einem verzweigten Stromnetz.

Das verzweigte Stromnetz 2 weist eine Hauptader mit drei stromdurchflossenen Leitern (L1-L3) und einem Neutralleiter (N) auf, welche sich zu den Verbrauchern 1 hin verzweigen. Der zentrale Einspeisepunkt 14 versorgt das gesamte verzweigte Stromnetz 2 mit elektrischer Energie.

Um die tatsächliche Menge an vom Verbraucher 1 entnommener elektrischer Energie oder die tatsächliche Leistungsaufnahme zu ermitteln, erfolgen eine zentrale Bestimmung der Spannung mittels einer zentralen Spannungswandlereinheit 3 und eine dezentrale Bestimmung des Stroms in den dezentralen Einheiten, wobei in Fig. 1 eine dezentrale Einheit 4 stellvertretend detailliert dargestellt ist. Die anderen dezentralen Einheiten 4.n werden nur vereinfacht dargestellt, wobei das das "n"- im Bezugszeichen für eine beliebige natürliche Zahl steht und so eine beliebige Anzahl an dezentralen Einheiten darstellen soll.

Die zentrale Spannungswandlereinheit 3 ist an einem verzweigten Stromnetz 2 getrennt von der dezentralen Einheit 4 angeordnet. Die zentrale Spannungswandlereinheit 3 bestimmt die Augenblickswerte der Spannung im verzweigten Stromnetz 2 an zentraler Stelle und wandelt diese in ein reduziertes Spannungsreferenzsignal als analoges Signal um. Dieses wird in dem vorliegenden Ausführungsbeispiel kabelgebunden über die Spannungssignalverbindung 8 an die dezentrale Auswertungseinheit 7 der dezentralen Einheit 4 übertragen.

Hierbei weist die Spannungssignalverbindung 8 einen Analog-Digital-Wandler 8.2 auf, der das Spannungssignal in ein digitales Format überträgt, so dass es in dem dort beginnenden digitalen Spannungssignalverbindungsabschnitt 8.1 als digitales Spannungsreferenzsignal weiter übertragen wird. Das digitale Spannungsreferenzsignal wird durch den Digital-Analog-Wandler 8.3 in ein analoges Spannungsreferenzsignal rückumgewandelt und digital an die dezentrale Einheit 4 übergeben. Ferner wird zusätzlich gemäß dem Ausführungsbeispiel an die weitere dezentrale Einheit 4.n das Spannungsreferenzsignal im digitalen Format übergeben.

Die dezentrale Einheit 4 weist eine dezentrale Strommessanordnung 5 und eine dezentrale Auswertungseinheit 7 auf.

Die dezentrale Strommessanordnung 5 weist ihrerseits drei Stromsensoren 6 auf, welche den Stromleitern L 1-3 des verzweigten Stromnetzes 2 zugeordnet sind. Die Stromsensoren ermitteln die Augenblickswerte des Stroms der drei Stromleiter L 1 bis L 3 und übermitteln diese an die Strommesseinheit 15. Die dezentrale Strommessanordnung 5 liefert die Augenblickswerte des Stroms an die dezentrale Auswertungseinheit 7 der dezentralen Einheit 4.

Die dezentrale Auswertungseinheit 7 berechnet aus dem reduzierten Spannungsreferenzsignal, welches über die Spannungssignalverbindung 8 von der zentralen Spannungswandlereinheit 3 übertragen wird und den Augenblickswerten des Stroms die Wirkleistung, welche von dem betreffenden Verbraucher 1 aufgenommen wird. Als elektrische Kenngrößen werden im vorliegenden Ausführungsbeispiel die Blindleistung, die Wirkleistung, die Scheinleistung, der Phasenverschiebungswinkel, die Spannung und der Strom zur Ausgabe bereitgestellt.

In dem vorliegenden Ausführungsbeispiel weist die Anordnung zudem eine zentrale Ausgabe- und Serviceeinheit 12 sowie zusätzliche dezentrale Ausgabe- und Serviceeinheiten 10 auf.

Die Werte für die entnommene Wirkleistung und die Werte der weiteren elektrischen Kenngrößen werden in dem vorliegenden Ausführungsbeispiel durch die dezentrale Auswertungseinheit 7 über die zentrale Datenverbindung 13 an die zentrale Ausgabe- und Serviceeinheit 12 übertragen.

In dieser Ausführung ist eine dezentrale Ausgabeeinheit 10 über die dezentrale Datenverbindung 11 mit der dezentralen Auswertungseinheit 7 verbunden. In dieser Ausführung ist die dezentrale Ausgabe- und Serviceeinheit 10 als ein externes Gerät, konkret als PC ausgebildet, welches ein Auslesen der Wirkleistung und weiterer elektrischer Kenngrößen dezentral für den einzelnen Verbraucher ermöglicht. Gemäß dieser Ausführung ist die zentrale Datenverbindung 13 als digitaler Bus ausgebildet.

Das Verfahren wird in dem Ausführungsbeispiel wie folgt durchgeführt:
Im ersten Verfahrensschritt a) erfolgt eine zentrale Erfassung der Spannung mittels der zentralen Spannungswandlereinheit 3.

Die zentrale Spannungswandlereinheit 3 reduziert im nächsten Verfahrensschritt b) die am verzweigten Stromnetz 2 anliegende Spannung von 230 Volt um einen Wandlungsfaktor zu einer Sicherheitskleinspannung mit einer geringeren Spannung, vorliegend 12 Volt. Es wird lediglich der Betrag einschließlich Amplitude proportional verändert; die Spannungsform im Wechselstromkreis bleibt ebenso wie ihre Periodenlänge und Phasenlage für alle drei Phasen erhalten. Im Ergebnis wird so die Spannungsform und die Phasenlage aus der 230 V Ebene als das analoge Spannungsreferenzsignal in Sicherheitskleinspannung erhalten.

Das so entstandene Spannungsreferenzsignal wird im nächsten Verfahrensschritt c) über die Spannungssignalverbindung 8 an die dezentrale Auswertungseinheit 7 übertragen, wobei über den A/D-Wandler 8.2 zunächst eine Umwandlung in ein digitales Spannungsreferenzsignal und am Ende des digitalen Spannungssignalverbindungsabschnitts 8.1 durch den D/A-Wandler 8.3 eine Rückumwandlung in ein analoges Signal erfolgt.

In Verfahrensschritt d) erfassen die drei Stromsensoren 6 der dezentralen Strommessanordnung 5 die Augenblickswerte der durch die Leiter (L 1 bis L 3) fließenden elektrischen Ströme. Hierzu werden die von den Stromsensoren 6 aufgenommenen Werte durch die Strommesseinheit in ein Signalformat umgewandelt, welches von der dezentralen Auswertungseinheit 7 verarbeitet werden kann.

Diese Augenblickswerte werden in diesem Signalformat dann im Verfahrensschritt e) mittels der Stromsignalverbindung 9 an die dezentrale Auswertungseinheit 7 übertragen.

Insbesondere die Verfahrensschritte a) und b) sowie d) erfolgen zeitgleich.

Die dezentrale Auswertungseinheit 7 bestimmt aus dem Spannungsreferenzsignal die Augenblickswerte der Spannung (Verfahrensschritt f)).

Die Augenblickswerte der Spannung werden nachfolgend durch die dezentrale Auswertungseinheit 7 den Augenblickswerten des Stroms in Echtzeit zugeordnet (Verfahrensschritt g)).

Im letzten Verfahrensschritt h) wird aus den Augenblickswerten für Strom und Spannung sowie dem Wandlungsfaktor die Wirkleistung und weitere elektrische Kenngrößen errechnet.

Die errechneten elektrischen Kenngrößen werden über die dezentrale Datenverbindung 11 an die dezentrale Ausgabeeinheit 10 und zusätzlich über die zentrale Datenverbindung 13 an die zentrale Ausgabeeinheit 12 übermittelt.

In dieser Ausführung sind beide Datenverbindungen 11, 13 als jeweils eine physische Datenverbindung und die beiden Ausgabe- und Serviceeinheiten 10, 12 jeweils als PCs und damit als externe Geräte ausgebildet.

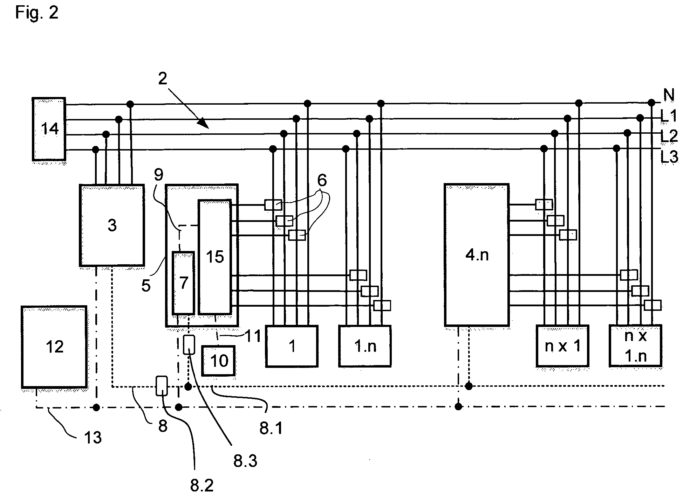

Figur 2 zeigt ein Ausführungsbeispiel der erfindungsgemäßen Anordnung mit Darstellung mehrerer Verbraucher.

Der Grundaufbau stimmt mit Fig. 1 überein, so dass die Erläuterungen und Bezugszeichen zu Fig. 1 auch auf Fig. 2 entsprechend zutreffen.

In dem Ausführungsbeispiel nach Fig. 2 sind jeweils einer dezentralen Einheit 4 mehrere Verbraucher 1, 1.n sowie einer weiteren dezentralen Einheit 4.n ebenfalls mehrere Verbraucher nx1, nx1.n zugeordnet. Hierzu weist beispielsweise die dezentralen Einheit 4 eine Strommessanordnung (in Fig. 2 ohne Bezugszeichen) mit mehreren Stromsensoren 6 auf, wobei jedem zu den Verbrauchern 1, 1.n führendem Stromleiter L1, L2, L3 jeweils ein Stromsensor 6 (bei dem Verbraucher 1.n ohne Bezugszeichen) zugeordnet ist.

Verwendete Bezugszeichen

| | |
|---|---|
| 1 | Verbraucher |
| 1.n | weiterer Verbraucher |
| nx1 | Verbraucher, zugeordnet einer weiteren dezentralen Einheit 4.n |
| nx1.n | weiterer Verbraucher, zugeordnet einer weiteren dezentralen Einheit 4.n |
| 2 | verzweigtes Stromnetz |
| 3 | zentrale Spannungswandlereinheit |
| 4 | dezentrale Einheit |
| 4.n | weitere dezentrale Einheiten |
| 5 | dezentrale Strommessanordnung |
| 6 | Stromsensor |
| 7 | dezentrale Auswertungseinheit |
| 8 | Spannungssignalverbindung |
| 8.1 | digitaler Spannungssignalverbindungsabschnitt |
| 8.2 | Analog-Digital-Wandler |
| 8.3 | Digital-Analog-Wandler |
| 9 | Stromsignalverbindung 10 dezentrale Ausgabe- und Serviceeinheit |
| 11 | dezentrale Datenverbindung |
| 12 | zentrale Ausgabe- und Serviceeinheit |
| 13 | zentrale Datenverbindung |
| 14 | zentraler Einspeisepunkt |
| 15 | Strommesseinheit |
| L1 | Stromleiter |
| L2 | Stromleiter |
| L3 | Stromleiter |
| N | Neutralleiter |

**Patentansprüche**

1. Anordnung zur Ermittlung elektrischer Kenngrößen von Verbrauchern (1) in einem verzweigten Stromnetz (2),

   aufweisend eine zentrale Spannungswandlereinheit (3) und eine Mehrzahl dezentraler Einheiten (4),
   wobei die zentrale Spannungswandlereinheit (3) ausgebildet ist, einen Spannungsverlauf zu erfassen und ein mit einem Wandlungsfaktor proportional zu dem Spannungsverlauf auf eine Sicherheitskleinspannung reduziertes Spannungsreferenzsignal zu erzeugen und dieses übertragbar bereitzustellen,
   wobei die dezentralen Einheiten (4) jeweils den Verbrauchern (1) zugeordnet sind, wobei jede dezentrale Einheit (4) eine dezentrale Strommessanordnung (5) und eine dezentrale Auswertungseinheit (7) aufweist,
   wobei die dezentrale Strommessanordnung (5) mindestens einen Stromsensor (6) aufweist und ausgebildet ist, einen Augenblickswert eines Stroms zu messen und übertragbar bereitzustellen,
   wobei die dezentrale Auswertungseinheit (7) mittels einer Spannungssignalverbindung (8) mit der zentralen Spannungswandlereinheit (3) und mittels einer Stromsignalverbindung (9) mit den jeweiligen dezentralen Strommessanordnungen (5) verbunden ist,
   wobei die Spannungssignalverbindung (8) einen digitalen Spannungssignalverbindungsabschnitt (8.1) aufweist, der durch einen Analog-Digital-Wandler (8.2) und einen Digital-Analog-Wandler (8.3) begrenzt wird,
   wobei die dezentrale Auswertungseinheit (7) ausgebildet ist, aus dem Spannungsreferenzsignal Augenblickswerte der Spannung zu detektieren und die Augenblickswerte der Spannung den Augenblickswerten des Stroms zuzuordnen und aus den zugeordneten Augenblickswerten der Spannung und des Stroms sowie aus dem Wandlungsfaktor die elektrische Wirkleistung des jeweiligen Verbrauchers (1) als eine elektrische Kenngröße zu berechnen.

2. Anordnung zur Ermittlung elektrischer Kenngrößen von Verbrauchern (1) in einem verzweigten Stromnetz (2) nach Anspruch 1,
   **dadurch gekennzeichnet,**
   **dass** die dezentrale Strommesseinheit (5) in die dezentrale Auswertungseinheit (7) integriert ist.

3. Anordnung zur Ermittlung elektrischer Kenngrößen von Verbrauchern (1) in einem verzweigten Stromnetz (2) nach Anspruch 1 oder 2,
   **dadurch gekennzeichnet,**
   **dass** die dezentrale Auswertungseinheit (7) ausgebildet ist, aus den Augenblickswerten der Spannung und des Stroms einen Phasenwinkel φ (phi) als eine elektrische Kenngröße zu berechnen.

4. Anordnung zur Ermittlung elektrischer Kenngrößen von Verbrauchern (1) in einem verzweigten Stromnetz (2) nach einem der vorhergehenden Ansprüche,
   **dadurch gekennzeichnet,**

   **dass** mindestens eine dezentrale Einheit (4) eine dezentrale Ausgabe- und Serviceeinheit (10) aufweist,
   wobei die dezentrale Auswertungseinheit (7) der mindestens einen dezentralen Einheit (4) eine dezentrale Datenverbindung (11) zu der dezentralen Ausgabe- und Serviceeinheit (10) aufweist und ausgebildet ist, die über die dezentrale Datenverbindung (11) erhaltenen elektrischen Kenngrößen der dezentralen Einheiten (4) dezentral auszugeben.

5. Anordnung zur Ermittlung elektrischer Kenngrößen von Verbrauchern (1) in einem verzweigten Stromnetz (2) nach einem der vorhergehenden Ansprüche,
   **dadurch gekennzeichnet,**

   **dass** sie eine zentrale Ausgabe- und Serviceeinheit (12) aufweist,
   wobei die dezentralen Auswertungseinheiten (7) über eine zentrale Datenverbindung (13) mit der zentralen Ausgabe- und Serviceeinheit (12) verbunden sind
   wobei die zentrale Ausgabe- und Serviceeinheit (12) ausgebildet ist, die über die zentrale Datenverbindung (13) erhaltenen elektrischen Kenngrößen der dezentralen Einheiten (4) zentral auszugeben.

6. Verfahren zur Ermittlung elektrischer Kenngrößen von Verbrauchern (1) in einem verzweigten Stromnetz (2)
   **dadurch gekennzeichnet,**

   **dass** mittels einer zentralen Spannungswandlereinheit (3), einer Mehrzahl von dezentralen Einheiten (4), welche den Verbrauchern (1) zugeordnet sind und eine dezentrale Strommessanordnung (5) mit mindestens einem Stromsensor (6) und eine dezentrale Auswertungseinheit (7) aufweisen, wobei die Spannungswandlereinheit (3) mittels einer Spannungssignalverbindung (8) mit der dezentralen Auswertungseinheit (7) und die dezentrale Strommessanordnung (5) mittels einer Stromsignalverbindung (9) mit der dezentralen Auswertungseinheit (7) verbunden ist,

aufweisend folgende Verfahrensschritte

a) zentrales Erfassen einer Spannung durch den zentralen Spannungswandler (3),

b) Wandeln der Spannung in ein Spannungsreferenzsignal, indem der Spannungsverlauf um einen Wandlungsfaktor proportional auf eine Sicherheitskleinspannung reduziert wird,

c) Übertragen des Spannungsreferenzsignals über die Spannungssignalverbindung (8) an die dezentrale Auswertungseinheit (7), hierbei Wandeln des analogen Spannungsreferenzsignals mittels des Analog-Digital-Wandlers (8.2) in ein digitales Spannungsreferenzsignal, übertragen des digitalen Spannungsreferenzsignals über den digitalen Spannungssignalverbindungsabschnitt (8.1) und Wandeln des digitalen Spannungsreferenzsignals mittels des Digital-Analog-Wandlers (8.3)

d) dezentrales Erfassen von Augenblickswerten eines Stroms durch die dezentralen Strommessanordnungen (5),

e) Übertragen der Augenblickswerte des Stroms mittels der Stromsignalverbindung (9) an die dezentrale Auswertungseinheit (7),

f) Ermitteln von Augenblickswerten der Spannung anhand des Spannungsreferenzsignals durch die dezentrale Auswertungseinheit (7),

g) Zuordnung der Augenblickswerte der Spannung und des Stroms in Echtzeit,

h) Berechnen der Wirkleistung aus den zugeordneten Augenblickswerten der Spannung und des Strom sowie aus dem Wandlungsfaktor

## Claims

1. An arrangement for determining electrical parameters of loads (1) in a branched power network (2),

   comprising a centralized voltage transformer unit (3) and a plurality of decentralized units (4),
   wherein the centralized voltage transformer unit (3) is designed to record a voltage characteristic and to generate a voltage reference signal reduced to a safety extra-low voltage by a conversion factor proportional to the voltage characteristic and to provide this signal in a transmittable form,
   wherein the decentralized units (4) are each assigned to the loads (1), wherein each decentralized unit (4) comprises a decentralized current measurement set-up (5) and a decentralized evaluation unit (7),
   wherein the decentralized current measurement set-up (5) comprises at least one current sensor (6) and is designed to measure an instantaneous value of a current and to provide it in a transmittable form,
   wherein the decentralized evaluation unit (7) is connected to the centralized voltage transformer unit (3) by means of a voltage signal connection (8) and to the respective decentralized current measurement set-ups (5) by means of a current signal connection (9),
   wherein the voltage signal connection (8) has a digital voltage signal connection section (8.1) which is delimited by an analogue-to-digital converter (8.2) and a digital-to-analogue converter (8.3),
   wherein the decentralized evaluation unit (7) is designed to detect instantaneous values of the voltage from the voltage reference signal and to assign the instantaneous values of the voltage to the instantaneous values of the current and to calculate the electrical active power of the respective load (1) as an electrical parameter from the assigned instantaneous values of the voltage and the current and from the conversion factor.

2. The arrangement for determining electrical parameters of loads (1) in a branched power network (2) according to claim 1,
   **characterized in**
   **that** the decentralized current measurement set-up (5) is integrated into the decentralized evaluation unit (7).

3. The arrangement for determining electrical parameters of loads (1) in a branched power network (2) according to claim 1 or 2,
   **characterized in**
   **that** the decentralized evaluation unit (7) is designed to calculate a phase angle $\varphi$ (phi) as an electrical parameter from the instantaneous values of the voltage and the current.

4. The arrangement for determining electrical parameters of loads (1) in a branched power network (2) according to one of the preceding claims, **characterized in**

   **that** at least one decentralized unit (4) comprises a decentralized output and service unit (10), wherein the decentralized evaluation unit (7) of the at least one decentralized unit (4) has a decentralized data connection (11) to the decentralized output and service unit (10) and is designed to output the electrical parameters of the decentralized units (4), obtained via the decentralized data connection (11), in a decentralized manner.

5. The arrangement for determining electrical parameters of loads (1) in a branched power network (2) according to one of the preceding claims, **characterized in**

   **that** it comprises a centralized output and service unit (12), wherein the decentralized evaluation units (7) are connected to the centralized output and service unit (12) via a centralized data connection (13), wherein the centralized output and service unit (12) is designed to output the electrical parameters of the decentralized units (4), obtained via the centralized data connection (13), in a centralized manner.

6. A method for determining electrical parameters of loads (1) in a branched power network (2) by means of a centralized voltage transformer unit (3) and a plurality of decentralized units (4), the latter being assigned to the loads (1) and each of them comprises a decentralized current measurement set-up (5) which has at least one current sensor (6) and a decentralized evaluation unit (7), wherein the voltage transformer unit (3) is connected to the decentralized evaluation unit (7) by means of a voltage signal connection (8), and the decentralized current measurement set-up (5) is connected to the decentralized evaluation unit (7) by means of a current signal connection (9), comprising the following process steps

   a) recording a voltage in a centralized manner by means of the centralized voltage transformer (3),
   b) transforming the voltage into a voltage reference signal by proportionally reducing the voltage characteristic to a safety extra-low voltage by a conversion factor,
   c) transmitting the voltage reference signal via the voltage signal connection (8) to the decentralized evaluation unit (7), and in doing so, converting the analogue voltage reference signal into a digital voltage reference signal by means of the analogue-to-digital converter (8.2), transmitting the digital voltage reference signal via the digital voltage signal connection section (8.1) and converting the digital voltage reference signal by means of the digital-to-analogue converter (8.3),
   d) recording instantaneous values of a current in a decentralized manner by means of the decentralized current measurement set-up (5),
   e) transmitting the instantaneous values of the current to the decentralized evaluation unit (7) via the current signal connection (9),
   f) determining instantaneous values of the voltage by the decentralized evaluation unit (7) on the basis of the voltage reference signal,
   g) assigning the instantaneous values of the voltage and the current in real time,
   h) calculating the active power from the assigned instantaneous values of the voltage and current as well as from the conversion factor.

**Revendications**

1. Dispositif pour déterminer les caractéristiques électriques de consommateurs (1) dans un réseau électrique ramifié (2),

   comprenant une unité centrale de transformation de tension (3) et une pluralité d'unités décentralisées (4), où l'unité centrale de transformation de tension (3) est conçue pour détecter une courbe de tension et pour produire un signal de référence de tension réduit à une basse tension de sécurité avec un facteur de transformation proportionnel à la courbe de tension et pour mettre celui-ci à disposition de manière transmissible, où les unités décentralisées (4) sont respectivement associées aux consommateurs (1), chaque unité décentralisée (4) présentant un dispositif de mesure de courant décentralisé (5) et une unité d'évaluation décentralisée (7), où le dispositif de mesure de courant décentralisé (5) présente au moins un capteur de courant (6) et est conçu pour mesurer une valeur instantanée d'un courant et la mettre à disposition de manière transmissible,
où l'unité d'évaluation décentralisée (7) est reliée au moyen d'une connexion par signal de tension (8) à l'unité de transformation de tension centrale (3) et au moyen d'une connexion par signal de courant (9) aux dispositifs de mesure de courant décentralisés respectifs (5),
où la connexion de signal de tension (8) comprend une section de connexion par signal de tension numérique (8.1) délimitée par un convertisseur analogique-numérique (8.2) et un convertisseur numérique-analogique (8.3), où l'unité d'évaluation décentralisée (7) est conçue pour détecter des valeurs instantanées de la tension à partir du signal de référence de tension et pour associer les valeurs instantanées de la tension aux valeurs instantanées du courant et pour calculer la puissance électrique active du consommateur respectif (1) en tant que grandeur électrique caractéristique à partir des valeurs instantanées associées de la tension et du courant ainsi qu'à partir du facteur de conversion.

2. Dispositif pour déterminer les caractéristiques électriques de consommateurs (1) dans un réseau électrique ramifié (2) suivant la revendication 1 est **caractérisé en ce**
   **que** le dispositif de mesure de courant décentralisé (5) est intégré dans l'unité d'évaluation décentralisée (7).

3. Dispositif pour déterminer les caractéristiques électriques de consommateurs (1) dans un réseau électrique ramifié (2) suivant la revendication 1 ou 2 est **caractérisé en ce**
   **que** l'unité d'évaluation décentralisée (7) est conçue pour calculer, à partir des valeurs instantanées de la tension et du courant, un angle de phase $\varphi$ (phi) en tant que grandeur électrique caractéristique.

4. Dispositif pour déterminer les caractéristiques électriques de consommateurs (1) dans un réseau électrique ramifié (2) suivant l'une quelconque des revendications précédentes
   est **caractérisé en ce**

   **qu'**au moins une unité décentralisée (4) présente une unité de sortie et de service décentralisée (10),
   où l'unité d'évaluation décentralisée (7) de l'au moins une unité décentralisée (4) présente une liaison de données décentralisée (11) vers l'unité de sortie et de service décentralisée (10) et est conçue pour émettre de manière décentralisée les grandeurs caractéristiques électriques des unités décentralisées (4) obtenues par la liaison de données décentralisée (11).

5. Dispositif pour déterminer les caractéristiques électriques de consommateurs (1) dans un réseau électrique ramifié (2) suivant l'une quelconque des revendications précédentes
   est **caractérisé en ce**

   **qu'**il présente une unité centrale de distribution et de service (12),
   où les unités d'évaluation décentralisées (7) sont reliées à l'unité centrale de sortie et de service (12) par l'intermédiaire d'une liaison centrale de données (13),
   où l'unité centrale de sortie et de service (12) est conçue pour sortir de manière centrale les grandeurs caractéristiques électriques des unités décentralisées (4) obtenues par la liaison centrale de données (13).

6. Procédé pour déterminer les caractéristiques électriques de consommateurs (1) dans un réseau électrique ramifié (2)
   est **caractérisé en ce**

   **qu'**au moyen d'une unité de transformation de tension centrale (3), d'une pluralité d'unités décentralisées (4) qui sont associées aux consommateurs (1) et qui présentent un dispositif de mesure de courant décentralisé (5) avec au moins un capteur de courant (6) et une unité d'évaluation décentralisée (7), où l'unité de transformation de tension (3) est reliée au moyen d'une liaison de signal de tension (8) à l'unité d'évaluation décentralisée (7) et le dispositif de mesure de courant décentralisé (5) au moyen d'une liaison de signal de courant (9) à l'unité d'évaluation décentralisée (7),
   comprenant les suivantes étapes de procédé

   a) saisie centrale d'une tension par le transformateur de tension central (3),
   b) conversion de la tension en un signal de référence de tension en réduisant proportionnellement la courbe de tension d'un facteur de conversion à une très basse tension de sécurité,
   c) transmission du signal de référence de tension à l'unité d'évaluation décentralisée (7) par l'intermédiaire de la section de liaison de signal de tension (8), en convertissant ici le signal de référence de tension analogique en un signal de référence de tension numérique au moyen du convertisseur analogique-numérique (8.2), transmission du signal de référence de tension numérique par l'intermédiaire de la section de liaison de signal de tension numérique (8.1) et conversion du signal de référence de tension numérique au moyen du convertisseur numérique-analogique (8.3),

d) saisie décentralisée de valeurs instantanées d'un courant par les dispositifs de mesure de courant décentralisés (5),

e) transmission des valeurs instantanées du courant à l'unité d'évaluation décentralisée (7) au moyen de la liaison de signal de courant (9),

f) détermination de valeurs instantanées de la tension à l'aide du signal de référence de tension par l'unité d'évaluation décentralisée (7),

g) attribution des valeurs instantanées de la tension et du courant en temps réel,

h) calcul de la puissance active à partir des valeurs instantanées correspondantes de la tension et du courant ainsi que du facteur de conversion.

Fig. 1

Fig. 2

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102011107932 B3
- EP 2960664 A1

- GB 2452989 A